# EUROPÄISCHE PATENTSCHRIFT

(11) **EP 1 040 506 B1**
(45) Veröffentlichungstag und Bekanntmachung des Hinweises auf die Patenterteilung: **04.09.2002**
(21) Anmeldenummer: 99947488.5
(22) Anmeldetag: 11.10.1999
(51) Int. Cl.: H01J 37/32, H05H 1/46

(54) **VORRICHTUNG ZUR ERZEUGUNG ANGEREGTER/IONISIERTER TEILCHEN IN EINEM PLASMA**
DEVICE FOR PRODUCING EXCITED/IONIZED PARTICLES IN A PLASMA
DISPOSITIF POUR PRODUIRE DES PARTICULES EXCITEES ET/OU IONISEES DANS UN PLASMA

(30) Priorität: 16.10.1998 DE 19847848
(43) Veröffentlichungstag der Anmeldung: 04.10.2000
(73) Patentinhaber: R 3 T GmbH Rapid Reactive Radicals Technology, 80687 München (DE)
(72) Erfinder: STEINHARDT, Heinz, A-2542 Kottingbrunn (AT); MATHUNI, Josef, D-81737 München (DE); GSCHWANDTNER, Alexander, D-80687 München (DE)
(74) Vertreter: Lang, Friedrich
(86) Internationale Anmeldenummer: EP9907617
(87) Internationale Veröffentlichungsnummer: WO00024031

(56) Entgegenhaltungen:
- EP-A- 0 432 573
- EP-A- 0 726 593
- DE-A- 3 915 477
- DE-A- 4 004 560
- DE-A- 19 608 949

## Beschreibung

Die vorliegende Erfindung betrifft eine Vorrichtung zur Erzeugung angeregter bzw. ionisierter Teilchen in einem Plasma.

Integrierte Schaltkreise, insbesondere Speicherbausteine oder Mikroprozessoren, werden mit einer Vielzahl von Prozeßschritten hergestellt. Die Herstellungskosten dieser Schaltkreise werden dabei durch die Prozeßkomplexität und die physikalische Bearbeitungszeit bestimmt. Hochkomplexe Bausteine erfordern häufig mehrere hundert einzelne Prozeßschritte und eine Vielzahl von Tagen für den Prozessdurchlauf des Produkts.

Ein Teil der Prozeßschritte muß dabei für das gezielte Aufbringen und die gezielte Entfernung von Material auf bzw. von der Halbleiteroberfläche eingesetzt werden. Die dazu verwendeten Ätz- bzw. Abscheidetechniken sind, neben der Lithographie und der Dotiertechnik, grundlegende Prozesse, die in der Prozeßfolge zur Herstellung von hochintegrierten Schaltungen auf Halbleitersubstraten immer wieder verwendet werden (vgl. allgemein "Technologie hochintegrierter Schaltungen", D. Widmann, H. Mader, H. Friedrich, Springerverlag 1988, insbesondere Abschnitte 3.1.1 und 5.2.2-4).

Ein wichtiges Verfahren zur Abscheidung von Material auf eine Halbleiteroberfläche ist die sogenannte chemische Gasphasenabscheidung, auch CVD-Verfahren (chemical vapor deposition) genannt. Dabei werden ausgewählte Prozeßgase über die aufgeheizten Halbleitersubstrate geleitet, auf denen die gewünschte Schicht abgeschieden werden soll. Auf der heißen Substratoberfläche kommt es zu der Reaktion der Prozeßgase, so daß als Reaktionsprodukte zum einen die gewünschte Schicht zum anderen Reaktionsgase entstehen, die aus dem Reaktor abgeführt werden. Es kann nun aus vielerlei Gründen unerwünscht sein, das Halbleitersubstrat auf die für den Ablauf der chemischen Reaktion notwendige, hohe Temperatur zu erhitzen. Daher ist es heute vielfach üblich, die Anregung der Ausgangs-Reaktionsgase zu dissoziierten, reaktionsfähigen Bestandteilen und die Auslösung der Abscheidereaktion nicht primär durch eine Erhöhung der Temperatur des Halbleitersubstrats vorzunehmen, sondern durch ein Plasma oder durch energiereiche Strahlung.

Zur Herstellung einer integrierten Schaltung ist es jedoch nicht ausreichend, Materialschichten auf ein Halbleitersubstrat nur aufzubringen. Zur Erzeugung der gewünschten Strukturen, müssen Teile dieser Schichten wieder gezielt entfernt werden. Dazu können eine Reihe von Verfahren eingesetzt werden, wobei das chemische Trockenätzen sowie das chemischphysikalische Trockenätzen die am häufigsten eingesetzten Verfahren sind. Beim chemischen Trockenätzen findet eine chemische Reaktion zwischen den Teilchen eines Gases und den Atomen der zu ätzenden Oberfläche statt. Beim chemischphysikalische Trockenätzen wird die chemische Reaktion zwischen den Teilchen eines Gases und den Atomen der zu ätzenden Oberfläche durch einen zusätzlichen Beschuß der zu ätzenden Oberfläche mit Ionen, Elektronen oder Photonen unterstützt. Wiederum kann es aus vielerlei Gründen unerwünscht sein, das Halbleitersubstrat auf die für den Ablauf der chemischen Reaktion notwendige, hohe Temperatur zu erhitzen. Daher ist es auch beim chemisch bzw. chemisch-physikalischen Trockenätzen üblich, die Anregung der Reaktionsgase zu dissoziierten, reaktionsfähigen Bestandteilen und die Auslösung der Ätzreaktion durch ein Plasma vorzunehmen.

Für die erfolgreiche Durchführung derartiger Ätz- und Abscheideprozesse kommt es darauf an, energiereiche und deshalb reaktionsfähige neutrale Teilchen, insbesondere Radikale, mit ausreichend hohem Wirkungsgrad zu generieren. Die technische Lösung dieses Erfordernisses wird zunehmend gleichzeitig mit einer Erfüllung der weitergehenden Forderungen nach einer Verhinderung des Einflusses elektrischer Felder und geladener Teilchen auf das zu prozessierende Substrat und nach einem möglichst weiten Arbeitsdruckbereich für die Ätz- und Abscheideprozesse angestrebt.

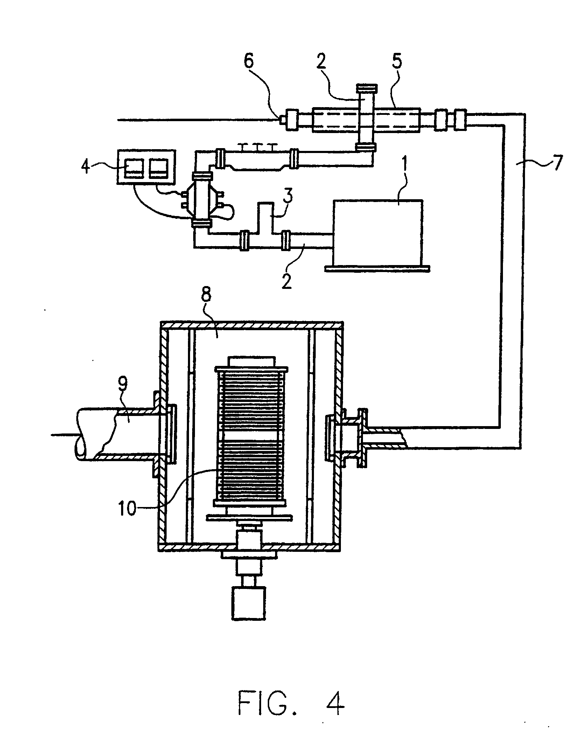

Zur Generierung reaktionsfähiger neutraler Teilchen werden in der Regel Hochfrequenz-Entladungen eingesetzt. Ein derartiges System zeigt beispielsweise Fig. 4, die dem Verkaufsprospekt "Model CDE-VIII Microwave Downstream Etching System", Specification # 840008, 1 April 1986 Revision 2 der Firma TYLAN/TOKUDA, USA entnommen ist. Es ist dort schematisch ein bekanntes, handelsübliches Downstream-Ätzsystem mit Mikrowellenanregung dargestellt.

In Fig. 4 ist ein Mikrowellengenerätor 1 gezeigt, der Mikrowellen erzeugt, die in ein Hohlleitersystem 2 eingekoppelt werden. Mit Hilfe einer Abstimmeinheit 4 und durch die Dimensionierung des Hohlleitersystems 2 bildet sich eine stehende Welle aus, durch die die Mikrowellenenergie an vorbestimmten Stellen des Hohlleitersystems 2 konzentriert wird. Die unabgestimmt reflektierte und nicht umgesetzte Energie muß irgendwo im Hohlleitersystem 2, beispielsweise im T-Stück 3 oder am Ende des Hohlleiters 2, absorbiert werden, was meistens mittels einer Wasserlast geschieht. Zum Generieren von Radikalen durch Mikrowellenenergie ist ein Plasmaentladungsrohr 5, das in Richtung des elektrischen Feldes der stehenden Welle ausgerichtet ist, durch das Hohlleitersystem 2 durchgeführt. Werden geeignete Prozeßgase dem Eingang 6 des Plasmaentladungsrohres 5 zugeführt und das Plasma gezündet, so entstehen, neben anderen, auch angeregte Neutralteilchen. Diese werden anschließend mittels einer Zuleitung 7, die etwa 1 m lang ist, zur Ätzreaktions-Reaktionskammer 8 transportiert. Damit gelangen angeregte neutrale Teilchen auf die Oberfläche von auf einem Drehtisch befestigten Substratscheiben 10, wo sie die gewünschten Ätzreaktionen auslösen. Die Reaktionskammer 8 wird mittels einer Pumpe 9 evakuiert und die flüchtigen Reaktionsprodukte werden abgesaugt.

Für einen reibungslosen Betrieb der Vorrichtung muß das Plasmaentladungsrohr aus einem Material gefertigt sein, das Mikrowellen kaum absorbiert und beständig gegen die im Plasma generierten, chemisch aggressiven Radikale ist. Dazu werden in der Regel Metalloxide oder Quarz verwendet. Diese Werkstoffe werden jedoch von reduzierenden Gasen, wie beispielsweise Wasserstoff, in der Plasmazone stark angegriffen, wodurch leitende Inseln in den Oberflächen dieser Werkstoffe entstehen können, was wiederum zu einer erhöhten Absorbtion der Mikrowellenenergie führt.

Problematisch bei dieser Art von Downstream-Ätzsystemen ist die Abstimmung der stehenden Welle. Die stehende Welle muß so abgestimmt werden, daß exakt ein Spannungsmaximum der Plasmaentlaladung zur Verfügung steht. Selbst geringe Fehlabstimmung führen zu deutlichen Veränderungen der Prozeßparameter, was wiederum eine Überlastung des Mikrowellengenerators zur Folge haben kann. Mit aufwendigen und kostenintensiven Maßnahmen kann die Überlastung des Mikrowellengenerators zwar verhindert werden. Diese Maßnahmen verringern jedoch den Wirkungsgrad und führen darüber hinaus zu einer deutlich Vergrößerung der gesamten Vorrichtung. Bedingt durch die Größe der Vorrichtung können diese Systeme nur noch mit großem Aufwand in Halbleiterproduktionsanlagen integriert werden. Kommt es zu einem Austausch von Verschleißteilen, wie beispielsweise Mikrowellengenerator oder Plasmaentladungsrohr, so muß die gesamte Vorrichtung neu abgestimmt werden.

Trotz einer genauen Abstimmung wird jedoch ein erheblicher Teil der Energie nicht zur Anregung umgesetzt, sondern reflektiert und muß im Hohlleiter, meist in einer Wasserlast, absorbiert werden, um nicht den Mikrowellengenerator, beispielsweise ein Magnetron, zu beschädigen. Diese teilweise Umsetzung der zur Verfügung stehenden Mikrowellenenergie, erweist sich besonders im Lichte der oben bereits genannten Forderung nach einem weiten Arbeitsdruckbereich insofern als problematisch, als für die Halbleitertechnologie gerade auch der niedrige Druckbereich unterhalb etwa 13, insbesondere unter 1,3 Pa interessant und von Vorteil ist. Niedrige Drücke sind beispielsweise für oberflächenkontrollierte CVD-Prozesse zur Vermeidung von Abscheidungen mit unerwünschten Schichteigenschaften von Bedeutung. Auch bei Ätzprozessen sind eine hohe Ätzrate und die Verhinderung von Mikroload-Effekten, also einer von der Umgebung abhängigen lokalen Ätzrate, oft nur bei sehr niedrigen Drucken zu verwirklichen. Bereits im Druckbereich unter 13 Pa beginnen jedoch Zündschwierigkeiten bei der Plasmaentladung aufzutreten, da die Anregungsdichte und damit auch der Wirkungsgrad der Generierung zu sehr abnehmen.

Eine gattungsgemäße Vorrichtung zur Erzeugung angeregter und/oder ionisierter Teilchen in einem Plasma aus einem Prozeßgas ist in der DE 39 05 303 A1 beschrieben. Die dort offenbarte Vorrichtung weist einen Generator zur Erzeugung einer elektromagnetischen Welle, einen Koaxialleiter, in welchen die elektromagnetische Welle geleitet wird, und zumindest eine Plasmazone auf, in der die angeregten und/oder ionisierten Teilchen durch die elektromagnetische Welle gebildet werden. Die Plasmazone ist bei der Vorrichtung der DE 39 05 303 A1 in einer isolierenden Entladungsröhre vorgesehen, welche zumindest teilweise innerhalb des Innenleiters eines koaxialen Wellenleiters angeordnet ist. Es wird dabei außerhalb der Entladungsröhre in einem Bereich zwischen dem gegen den Außenleiter verkürzten Innenleiter und einer den Außenleiter abschließenden Endplatte ein elektrisches Mikrowellenfeld erzeugt.

Weitere Vorrichtungen zur Erzeugung angeregter und/oder ionisierter Teilchen in einem Plasma sind in der DE 39 15 477 A1, der DE 40 04 560 A1 sowie in der DE 40 28 525 A1 offenbart. Bei den dort beschriebenen Vorrichtungen wird wiederum jeweils in einem Entladungsrohr, welches innerhalb des Innenleiters eines koaxialen Wellenleiters angeordnet ist, ein Plasma erzeugt.

Eine Vorrichtung zur Erzeugung von leistungsfähigen Mikrowellenplasmen ist weiterhin aus der DE 196 08 949 A1 bekannt. Der Resonator ist dabei ebenfalls als Koaxial-Resonator mit Innen- und Außenleiter ausgebildet. Das Plasma wird in einer Plasmakammer erzeugt, welche vom Innenleiter umschlossen wird oder seinerseits den Außenleiter umschließt.

In der DE 41 32 558 C1 ist außerdem ein Verfahren sowie eine Vorrichtung zur Generierung von angeregten neutralen Teilchen mittels einer durch Mikrowellenenergie gespeisten Plasmaentladung beschrieben. Es ist dabei ein Plasmaentladungsrohr, dessen Durchmesser einer Viertelwellenlänge der stehenden Mikrowelle entspricht, senkrecht zu einem Hohlleitersytem angeordnet. In dem Hohlleitersystem wird eine transversalelektrische Mikrowellenmode durch einen entsprechenden Generator angeregt.

Es ist weiterhin bekannt, das Plasma mit Hilfe des Einschließens in einem Magnetfeld, dessen Zyklotronfrequenz in Resonanz mit der Frequenz der Mikrowellen steht (ECR-Verfahren), auch im Druckbereich unter 13 x 10⁻² Pa zu stabilisieren. Jedoch können selbst mit derartigen Verfahren angeregte Neutralteilchen nicht in ausreichender Zahl und Dichte zur Verfügung gestellt werden. Dies ist nicht überraschend angesichts der Tatsache, daß auch bei einem verbesserten ECR-Verfahren nur gut 30% der Mikrowellenenergie in der Entladung umgesetzt werden.

Es ist daher die Aufgabe der vorliegenden Erfindung, eine Vorrichtung bereitzustellen, die die genannten Nachteile des Standes der Technik vermeidet oder mindert. Insbesondere ist es eine Aufgabe der Erfindung, eine Vorrichtung anzugeben, die auch im Druckbereich unterhalb etwa 13 Pa einen genügend hohen Wirkungsgrad besitzt und eine ausreichende Menge an angeregten/ionisierten Teilchen zur Verfügung stellt.

Diese Aufgabe wird von der Vorrichtung gemäß Patentanspruch 1 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen.

Erfindungsgemäß wird eine Vorrichtung zur Erzeugung angeregter und/oder ionisierter Teilchen in einem Plasma aus einem Prozeßgas mit einem Generator zur Erzeugung einer elektromagnetischen Welle, einem Koaxial-Leiter, in welchem die elektromagnetische Welle geleitet wird und zumindest einer Plasma zone, in der die angeregten und/oder ionisierten Teilchen durch die elektromagnetische Welle gebildet werden, bereitgestellt. Die erfindungsgemäße Vorrichtung ist dadurch gekennzeichnet, dass ein Einlass zur Zuführung des Prozeßgases in einen Innenraum des Koaxial-Leiters zwischen einem Außenleiter und einem Innenleiter vorhanden ist, und dass der Innenraum die Plasmazone bildet.

Die erfindungsgemäße Vorrichtung benötigt im wesentlichen keine Abstimmung, da keine Resonanzbedingungen eingehalten werden müssen und keine stehende Welle mit einem Spannungsmaximum an einer bestimmten Stelle zur Plasmagenerierung vorhanden sein muß. Die Plasmazone ist an einer Stelle des Koaxialleiters angeordnet, an der sich normalerweise bei einem Koaxialleiter das Dielektrikum befindet. Das Plasma in der Plasmazone stellt somit ein "verlustreiches Dielektrikum" dar, das in einem Ersatzschaltbild zusätzlich mit einem ohmschen Beiwert beschrieben wird.

Die Energie der elektromagnetischen Welle wird daher direkt mit einem hohen Wirkungsgrad in ein hochdichtes Plasma umgesetzt. Durch die ohmsche Belastung erfährt die elektromagnetische Welle eine hohe Bedämpfung, so daß eine Abstimmung der Vorrichtung überflüssig ist.

Mit anderen Worten, die in der Plasmazone stattfindende Plasmaentladung bedämpft das System und macht es breitbandig.

Somit kann bei der erfindungsgemäßen Vorrichtung auf komplizierte Abstimmeinheiten sowie eine zusätzliche Wasserlast verzichtet werden. Die erfindungsgemäße Vorrichtung ermöglicht daher eine sehr kleine und kompakte Bauweise, die sich leicht in die bestehenden Produktions- oder Laboranlagen integrieren läßt. Darüber hinaus ist die Wartung der erfindungsgemäßen Vorrichtung deutlich vereinfacht, wodurch sich Wartungskosten einsparen lassen.

Der Koaxialleiter weist einen Innenleiter und einen Außenleiter auf. Da die Impedanz eines Koaxialleiters durch den Außendurchmesser des Innenleiters, den Innendurchmesser des Außenleiters und der Dielektrizitätskonstanten des Mediums zwischen Innen- und Außenleiter bestimmt ist, ist Anpassung der Vorrichtung besonders einfach.

Bevorzugt ist der Generator zur Erzeugung der elektromagnetischen Welle ein Magnetron und somit kann eine Mikrowellenanregung erfolgen.

Die erfindungsgemäße Vorrichtung besitzt den Vorteil, daß der Außenleiter und/oder der Innenleiter aus Metall, bevorzugt aus Aluminium gefertigt werden können. Die Verwendung von Metall in der Plasmazone ermöglicht auf einfache Weise den Einsatz reduzierender Gase, wie beispielsweise Wasserstoff.

Bei Prozeßgasen, die das verwendete Metall angreifen, ist es bevorzugt, wenn ein durch Oxid bzw. durch Quarz beschichtetes Metall oder metallisierte Oxid- bzw. Quarzrohre verwendet werden.

Weiterhin besitzt die erfindungsgemäße Vorrichtung den Vorteil, daß der Innenleiter und/oder der Außenleiter des Koaxialleiters gekühlt werden können. Insbesondere ist es bevorzugt, wenn der Innenleiter und/oder der Außenleiter des Koaxialleiters durch eine Wasserkühlung gekühlt werden. Durch die Kühlung können die vom Plasma berührten Wände auf kontrolliert niedriger Temperatur gehalten werden. Dadurch wird zum einen der Materialverschleiß der Bauteile und die daraus resultierende Kontamination und Partikelbelastung deutlich vermindert. Zum anderen wird die reduzierende Wirkung von reduzierenden Gasen an den vom Plasma berührten Wänden wesentlich verringert.

Weiterhin ist bevorzugt, wenn die elektromagnetische Welle über einen Impedanzwandler in den Koaxialleiter geführt wird. Der Generator der elektromagnetischen Welle muß somit nicht selbst auf den Koaxialleiter angepaßt sein, wodurch eine größere Auswahl an Generatoren zur Verfügung steht. Der Impedanzwandler kann beispielsweise einen Hohlleiter und Impedanzwandlerkegel umfassen.

Darüber hinaus ist es insbesondere bevorzugt, wenn an der erfindungsgemäßen Vorrichtung ein Magnetsystem vorgesehen ist. Durch die Verwendung eines Magnetsystem sind Prozeßdrücke von unter einem 1 Pa möglich. Bevorzugt umfaßt das Magnetsystem eine oder mehrere Magnetfeldspulen sowie Magnetringe an der Außenseite des Außenleiters. Dabei können die Magnetringe auch durch Polschuhringe ersetzt werden. Weiterhin sind bevorzugt im Innenleiter Stabpolschuhe oder Stabmagnete vorgesehen, welche zur lokalen Feldverstärkung und Korrektur des Feldverlaufs eingesetzt werden können.

Weiterhin ist es möglich, daß zwischen dem Generator für die elektromagnetische Welle oder dem Impedanzwandler und der Plasmazone ein Transportbereich vorgesehen ist, in dem die elektromagnetische Welle im wesentlichen verlustfrei transportiert wird. Durch die Verwendung eines Transportbereichs erhält man bei dem Betrieb der erfindungsgemäßen Vorrichtung zusätzlichen Spielraum. Der Generator für die elektromagnetische Welle und die Plasmazone müssen nicht mehr direkt benachbart angeordnet werden, sondern können unabhängig voneinander räumlich getrennt plaziert werden. Dabei ist es insbesondere bevorzugt, wenn der Transportbereich als Koaxialleiter ausgebildet ist.

Weiterhin ist es bevorzugt, wenn ein Sensorsystem zur Überwachung des Plasmas in der Plasmazone vorgesehen ist. Sollte es beispielsweise zu einem Fehler bei Zünden des Plasma kommen, kann dies durch das Sensorsystem festgestellt und der Generator abgeschaltet werden. Eine Schädigung des Generators durch reflektierte Welle kann somit verhindert werden.

Die Erfindung wird nun anhand der Figuren der beiliegenden Zeichnungen näher erläutert. Es zeigen:
- Fig. 1: eine schematische Darstellung einer ersten Ausführungsform der erfindungsgemäßen Vorrichtung;
- Fig. 2: eine schematische Darstellung einer zweiten Ausführungsform der erfindungsgemäßen Vorrichtung;
- Fig. 3: eine schematische Darstellung einer dritten Ausführungsform der erfindungsgemäßen Vorrichtung; und
- Fig. 4: eine schematische Darstellung einer Vorrichtung zur Erzeugung angeregter Teilchen nach dem Stand der Technik.

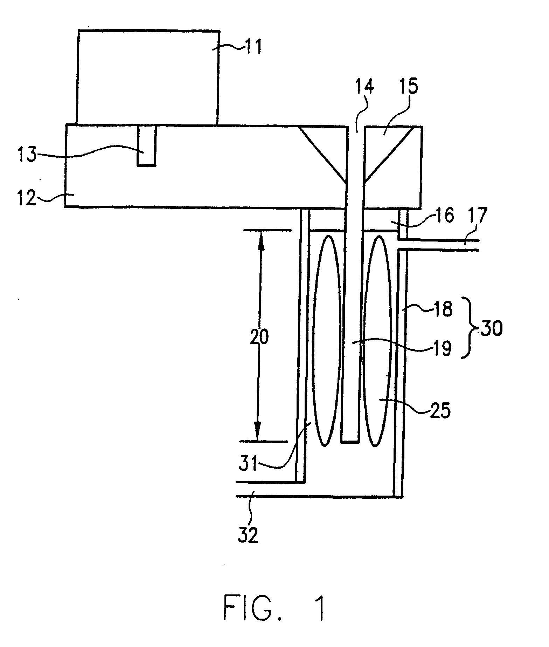

Fig. 1 zeigt eine schematische Darstellung einer ersten Ausführungsform der erfindungsgemäßen Vorrichtung. Dabei ist mit dem Bezugszeichen 11 ein Generator zur Erzeugung einer elektromagnetischen Welle bezeichnet. Bei dieser Ausführungsform ist der Generator 11 ein Magnetron, das Mikrowellen erzeugt. Über einen Einkoppelstift 13 wird die Mikrowelle in einen Hohlleiter 12 einkoppelt. In der Nähe des dem Einkoppelstift 13 gegenüberliegenden Endes des Hohlleiters 12 ist ein Impedanzwandlerkegel 15 angeordnet, der dazu dient, die Mikrowelle in einen Koaxialleiter 30 zu führen. Der Hohlleiter 12 und der Impedanzwandlerkegel 15 wirken somit wie ein Impedazwandler, wodurch die Mikrowelle möglichst ohne Reflexionen in den Koaxialleiter 30 geleitet werden kann.

Der Koaxialleiter 30 umfaßt dabei den Außenleiter 18 und den Innenleiter 19, zwischen denen sich im Innenraum 31 des Koaxialleiters 30 die Plasmazone 20 ausbildet. Über einen Einlaß 17 werden die Prozeßgase in den Innenraum 31 des Koxialleiters 30 geführt. Um zu verhindern, daß Prozeßgase in den Hohlleiter 12 gelangen, ist eine Abdichtung 16 vorgesehen, die den Hohlleiter 12 gegen den Innenraum 31 trennt. Die Länge der Plasmazone 20 und damit die Plasmadichte wird dabei durch die Länge des Innenleiters 19 bestimmt.

Damit die Länge der Plasmazone 20 und damit die Dichte des Plasmas 25 unterschiedlichen Anforderungen angepaßt werden kann, ist der Innenleiter 19 verschiebbar angeordnet. Die Impedanz des Koaxialleiters 30 ist durch den Außendurchmesser des Innenleiters 19, den Innendurchmesser des Außenleiters 18 und der Dielektrizitätskonstanten des Mediums zwischen Innen - und Außenleiter bestimmt. Da die Impedanz des Koaxialleiters 30 nicht von der Länge des Innenleiters 19 abhängt, kann die Länge der Plasmazone 20 verändert werden, ohne daß sich die Impedanz des Koaxialleiters 30 verändert.

In der Plasmazone 20 kommt es aufgrund der Wechselwirkung der Prozeßgase mit der Mikrowelle zu einer Plasmaentladung, wodurch angeregte und/oder ionisierte Teilchen entstehen. Nach dem Verlassen der Plasmazone 20 werden die angeregten und/oder ionisieren Teilchen über einen Auslaß 32 zu einer Reaktionskammer (nicht gezeigt) geführt, in der die angeregten und oder ionisierten Teilchen für weitere Reaktionen genutzt werden.

Je nach Anwendungszweck kann die erfindungsgemäße Vorrichtung so ausgelegt werden, daß beispielsweise im wesentlichen nur angeregte Teilchen und keine ionisierten die Plasmazone 20 verlassen. Dies ist insbesondere dann wichtig, wenn die angeregten Teilchen für Ätz- und Abscheideprozeße verwendet werden. Eine Belastung der zu behandelden Substrate durch ionisierte Teilchen kann somit vermieden werden.

Der Außenleiter 18 und der Innenleiter 19 können aus Metall, bevorzugt aus Aluminium gefertigt werden. Die Verwendung von Metall in der Plasmazone ermöglicht auf einfache Weise den Einsatz reduzierender Gase, wie beispielsweise Wasserstoff.

Bei Prozeßgasen, die das verwendete Metall angreifen, ist es bevorzugt, wenn ein durch Oxid bzw. durch Quarz beschichtetes Metall oder metallisierte Oxid bzw. Quarzrohre verwendet werden. Die erfindungsgemäße Vorrichtung besitzt den Vorteil, daß der Koaxialleiter 30 mit Wasser gekühlt werden kann. Dazu ist in dem Impedanzwandlerkegel 15 ein Wassereinlaß 14 für den Innenleiter 19 vorgesehen. Der Außenleiter 18 ist ebenfalls wassergekühlt. Wasserkühlung ist bei der erfindungsgemäßen Vorrichtung einsetzbar, weil das Wasser in keinem Fall der Mikrowellenenergie ausgesetzt wird, obwohl es parallel zur Plasmazone 20 fließt. Durch die Wasserkühlung können die vom Plasma 25 berührten Wände auf kontrolliert niedriger Temperatur gehalten werden. Dadurch wird zum einen der Materialverschleiß der Bauteile und die daraus resultierende Kontamination und Partikelbelastung deutlich vermindert. Zum anderen wird die reduzierende Wirkung von reduzierenden Gasen an den vom Plasma berührten Wänden wesentlich verringert. Gleichzeitig wird die Generierung der angeregten und/oder ionisierten Teilchen verbessert.

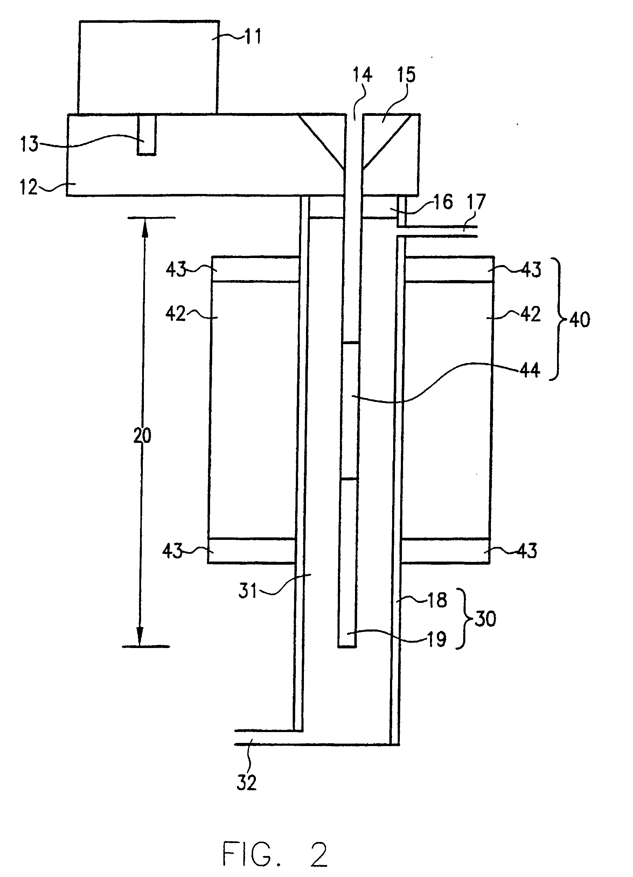

Fig. 2 zeigt eine schematische Darstellung einer zweiten Ausführungsform der erfindungsgemäßen Vorrichtung. Dabei sind gleiche Bestandteile mit gleichen Bezugszeichen wie in Fig. 1 versehen.

Zur Erweiterung des Anwendungsbereichs der erfindungsgemäßen Vorrichtung ist bei in Fig. 2 gezeigten Ausführungsform ein Magnetsystem 40 vorgesehen. Das Magnetsystem 40 umfaßt eine Magnetfeldspule 42 und Magnetringe 43 an der Außenseite des Außenleiters 18 in Höhe der Plasmazone 20. Dabei können die Magnetringe 43 auch durch Polschuhringe ersetzt werden. Weiterhin sind im Innenleiter 19 Stabpolschuhe oder Stabmagnete 44 vorgesehen, welche zur lokalen Feldverstärkung und Korrektur des Feldverlaufs eingesetzt werden können.

Diese Maßnahmen erlauben Prozeßdrücke unter 1 Pa. Die Kombination von Magnetspule und Festmagnet, verringert den Energiebedarf des Magnetsystems und erhöht gleichzeitig den Wirkungsgrad.

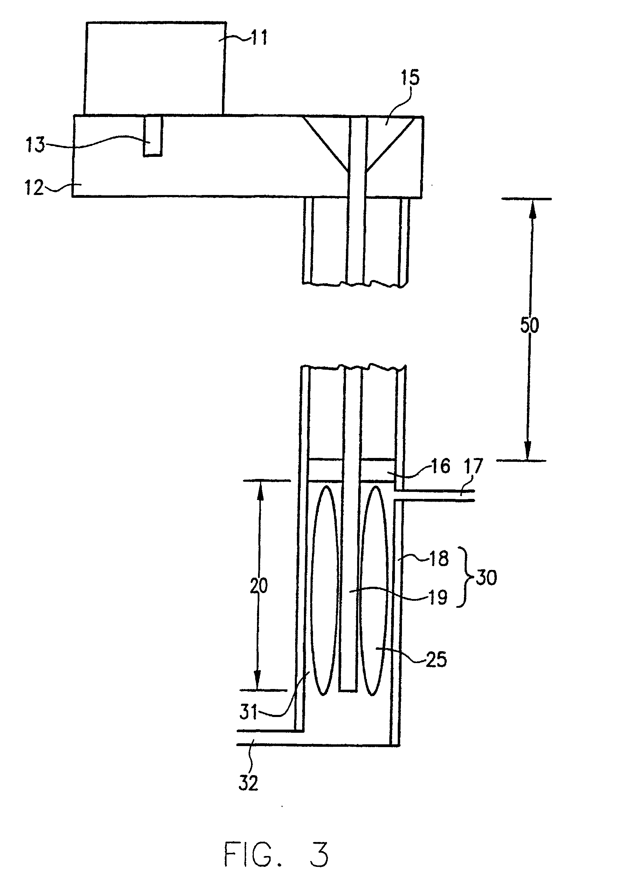

Fig. 3 zeigt eine schematische Darstellung einer dritten Ausführungsform der erfindungsgemäßen Vorrichtung. Dabei sind wiederum gleiche Bestandteile mit gleichen Bezugszeichen wie in Fig. 1 versehen.

Die in Fig.3 gezeigte Ausführungsform der erfindungsgemäßen Vorrichtung ist dadurch gekennzeichnet, daß zwischen dem Hohlleiter 12 und der Plasmazone 20 ein zusätzlicher Transportbereich 50 vorgesehen ist, der die Mikrowelle von dem Hohlleiter 12 zu der Plasmazone 20 leitet. Dabei ist der Transportbereich 50 ebenfalls als Koaxialleiter ausgebildet.

Durch die Verwendung eines Transportbereichs 50 erhält man bei dem Betrieb der erfindungsgemäßen Vorrichtung zusätzlichen Spielraum. Der Generator 11 der elektromagnetische Welle und die Plasmazone 20 können nun räumlich voneinander getrennt angeordnet werden, wenn dies durch die Gegebenheiten bei der Anwendung von Vorteil ist. Da die Mikrowelle mit einen Koaxialleiter nahezu verlustfrei geführt werden kann, wird der Wirkungsgrad der erfindungsgemäßen Vorrichtung durch diese Maßnahme nicht verändert.

Die erfindungsgemäße Vorrichtung besitzt einen hohen Wirkungsgrad und kann daher eine große Menge an angeregten/ionisierten Teilchen zur Verfügung stellen. Als Anwendungsbeispiel soll dazu die Ätzung einer Siliziumoberfläche mit angeregten Fluoratomen dienen. Bei einem Druck von 100 Pa werden NF₃ - Moleküle mit einem Fluß von 200 sccm in eine erfindungsgemäß Vorrichtung geleitet. Durch die Plasmaentladung in der Plasmazone 20 entstehen angeregte Fluoratome F*, die auf eine Siliziumoberfläche geführt werden. Auf der Siliziumoberfläche kommt es zu einer Reaktion der Siliziumatome mit den angergten Fluoratome, so daß flüchtiges SiF₄ entsteht. Durch die Verwendung der erfindungsgemäßen Vorrichtung läßt sich eine Ätzrate von etwa 5 µm/min erzielen. Aus dieser Ätzrate kann man schließen, daß die in den NF₃ - Molekülen vorhanden Fluoratome zu mehr als 80% zur Erzeugung von freien, angeregten Fluoratomen genutzt werden.

## Patentansprüche

1. Vorrichtung zur Erzeugung angeregter und/oder ionisierter Teilchen in einem Plasma aus einem Prozeßgas mit einem Generator (11) zur Erzeugung einer elektromagnetischen Welle, einem Koaxialleiter (30), in welchem die elektromagnetische Welle geleitet wird, und zumindest einer Plasmazone (20), in der die angeregten und/oder ionisierten Teilchen durch die elektro-magnetische Welle gebildet werden,
**dadurch gekennzeichnet,**
**daß** ein Einlaß (17) zur Zuführung des Prozeßgases in einen Innenraum (31) des Koaxialleiters (30) zwischen einem Aussenleiter (18) und einem Innenleiter (19) vorhanden ist, und daß der Innenraum die Plasmazone (20) bildet.

2. Vorrichtung nach Anspruch 1,
**dadurch gekennzeichnet,**
**daß** der Generator (11) zur Erzeugung einer elektromagnetischen Welle ein Magnetron ist.

3. Vorrichtung nach einem der Ansprüche 1 oder 2,
**dadurch gekennzeichnet,**
**daß** der Innenleiter (19) des Koaxialleiters (30) aus Metall, aus mit Oxid oder Quarz beschichtetem Metall oder aus metallisiertem Oxid oder Quarz gefertigt ist.

4. Vorrichtung nach einem der Ansprüche 1 oder 3,
**dadurch gekennzeichnet,**
**daß** der Außenleiter (18) des Koaxialleiters (30) aus Metall, aus mit Oxid oder Quarz beschichtetem Metall oder aus metallisiertem Oxid oder Quarz gefertigt ist.

5. Vorrichtung nach einem der Ansprüche 1 bis 4,
**dadurch gekennzeichnet,**
**daß** der Innenleiter (19) und/oder der Außenleiter (18) des Koaxialleiters (30) durch eine Kühlung, insbesondere durch eine Wasserkühlung, gekühlt werden.

6. Vorrichtung nach einem der Ansprüche 1 bis 5,
**dadurch gekennzeichnet,**
**daß** die elektromagnetische Welle über einen Impedanzwandler (12, 15) in den Koaxialleiter (30) geführt wird.

7. Vorrichtung nach Anspruch 6,
**dadurch gekennzeichnet,**
**daß** der Impedanzwandler (12, 15) einen Hohlleiter (12) und Impedanzwandlerkegel (15) umfaßt.

8. Vorrichtung nach einem der Ansprüche 6 oder 7,
**dadurch gekennzeichnet,**
**daß** zwischen dem Generator (11) für die elektromagnetische Welle oder dem Impedanzwandler (12, 15) und der Plasmazone (20) ein Transportbereich (50) vorgesehen ist, in dem die elektromagnetische Welle im wesentlichen verlustfrei transportiert wird.

9. Vorrichtung nach Anspruch 8,
**dadurch gekennzeichnet,**
**daß** der Transportbereich (50) als Koaxialleiter ausgebildet ist.

10. Vorrichtung nach einem der Ansprüche 1 bis 9,
**dadurch gekennzeichnet,**
**daß** die Länge der Plasmazone (20) veränderbar ist.

11. Vorrichtung nach einem der Ansprüche 1 bis 10,
**dadurch gekennzeichnet,**
**daß** ein Magnetsystem (40) vorgesehen ist.

12. Vorrichtung nach Anspruch 11,
**dadurch gekennzeichnet,**
**daß** das Magnetsystem (40) zumindest eine Magnetfeldspule (42) an der Außenseite des Außenleiters (18) umfaßt.

13. Vorrichtung nach Anspruch 11 oder 12,
**dadurch gekennzeichnet,**
**daß** das Magnetsystem (40) Magnetringe (43) und/oder Polschuhringe an der Außenseite des Außenleiters (18) umfaßt.

14. Vorrichtung nach einem der Ansprüche 11 bis 13,
**dadurch gekennzeichnet,**
**daß** das Magnetsystem (40) Stabpolschuhe oder Stabmagnete (44) im Innenleiter (19) umfaßt.

15. Vorrichtung nach einem der Ansprüche 1 bis 14,
**dadurch gekennzeichnet,**
**daß** ein Sensorsystem zur Überwachung des Plasmas (25) in der Plasmazone (20) vorgesehen ist.

## Claims

1. Device to generate excited and/or ionized particles in a plasma from a process gas with a generator (11) to generate an electromagnetic wave, a coaxial conductor (30) in which the electromagnetic wave is guided, and at least one plasma zone (20) in which the excited and/or ionized particles are formed by the electromagnetic wave, **characterized in that** an inlet (17) is available for inlet of the process gas into an interior chamber (31) of the coaxial conductor (30) between an outer conductor (18) and an inner conductor (19), and that the inner chamber forms the plasma zone (20).

2. Device according to Claim 1, **characterized in that** the generator (11) is a magnetron to generate an electromagnetic wave.

3. Device according to one of Claims 1 or 2, **characterized in that** the inner conductor (19) of the coaxial conductor (30) is manufactured from metal, from metal coated with oxide or quartz or from metallized oxide or quartz.

4. Device according to one of Claims 1 or 3, **characterized in that** the outer conductor (18) of the coaxial conductor (30) is manufactured from metal, metal coated with oxide or quartz, or from metallized oxide or quartz.

5. Device according to one of Claims 1 to 4, **characterized in that** the inner conductor (19) and/or the outer conductor (18) of the coaxial conductor (30) are cooled by means of cooling, in particular, by a water cooling.

6. Device according to one of Claims 1 to 5, **characterized in that** the electromagnetic wave is guided by means of an impedance converter (12, 15) into the coaxial conductor (30).

7. Device according to Claim 6, **characterized in that** the impedance converter (12, 15) is composed of a hollow waveguide (12) and impedance transformer cone (15).

8. Device according to one of Claim 6 or 7, **characterized in that** between the generator (11) for the electromagnetic wave or the impedance converter (12, 15) and the plasma zone (20), there is a transport region (50) in which the electromagnetic wave is transported essentially without loss.

9. Device according to Claim 8, **characterized in that** the transport region (50) is formed as a coaxial conductor.

10. Device according to one of Claims 1 to 9, **characterized in that** the length of the plasma zone (20) is variable.

11. Device according to one of Claims 1 to 10, **characterized in that** a magnetic system (40) is provided.

12. Device according to Claim 11, **characterized in that** the magnetic system (40) is composed of at least one magnetic field coil (42) on the outside of the outer conductor (18).

13. Device according to Claim 11 or 12, **characterized in that** the magnetic system (40) consists of magnetic rings (43) and/or pole shoe rings at the outside of the outer conductor (18).

14. Device according to one of Claims 11 to 13, **characterized in that** the magnetic system (40) is composed of rod pole shoes or rod magnets (44) in the inner conductor (19).

15. Device according to one of Claims 1 to 14, **characterized in that** a sensor system is provided to monitor the plasma (25) in the plasma.

## Revendications

1. Dispositif de production de particules excitées et/ou ionisées dans un plasma à partir d'un gaz de traitement avec un générateur (11) pour produire une onde électromagnétique, un conducteur coaxial (30) dans lequel l'onde électromagnétique est conduite, et au moins une zone plasma (20) dans laquelle les particules excitées et/ou ionisées sont formées par l'onde électromagnétique, ***caractérisé en ce qu***'une entrée (17) d'alimentation en gaz de traitement dans un espace intérieur (31) du conducteur coaxial (30) est présente entre un conducteur extérieur (18) et un conducteur intérieur (19), **et *en ce que*** l'espace intérieur forme la zone plasma (20).

2. Dispositif selon la Revendication 1, ***caractérisé en ce que*** le générateur (11) pour produire une onde électromagnétique est un magnétron.

3. Dispositif selon l'une quelconque des Revendications 1 ou 2, ***caractérisé en ce que*** le conducteur intérieur (19) du conducteur coaxial (30) est fabriqué en métal, en métal revêtu d'oxyde ou de quartz, ou en oxyde ou quartz métallisé.

4. Dispositif selon l'une quelconque des Revendications 1 à 3, ***caractérisé en ce que*** le conducteur extérieur (18) du conducteur coaxial (30) est fabriqué en métal, en métal revêtu d'oxyde ou de quartz, ou en oxyde ou quartz métallisé.

5. Dispositif selon l'une quelconque des Revendications 1 à 4, ***caractérisé en ce que*** le conducteur intérieur (19) et/ou le conducteur extérieur (18) du conducteur coaxial (30) est(sont) refroidi(s) par un refroidissement, en particulier un refroidissement par eau.

6. Dispositif selon l'une quelconque des Revendications 1 à 5, ***caractérisé en ce que*** l'onde électromagnétique est envoyée dans le conducteur coaxial (30) par l'intermédiaire d'un convertisseur d'impédance (12, 15).

7. Dispositif selon la Revendication 6, ***caractérisé en ce que*** le convertisseur d'impédance (12, 15) comprend un conducteur creux (12) et un cône convertisseur d'impédance (15).

8. Dispositif selon l'une quelconque des Revendications 6 ou 7, ***caractérisé en ce qu***'entre le générateur (11) pour l'onde électromagnétique ou le convertisseur d'impédance (12, 15) et la zone plasma (20), une zone de transport (50) est présente, dans laquelle l'onde électromagnétique est transportée pour l'essentiel sans perte.

9. Dispositif selon la Revendication 8, ***caractérisé en ce que*** la zone de transport (50) est conformée en conducteur coaxial.

10. Dispositif selon l'une quelconque des Revendications 1 à 9, ***caractérisé en ce que*** la longueur de la zone plasma (20) est variable.

11. Dispositif selon l'une quelconque des Revendications 1 à 10, ***caractérisé en ce qu***'un système magnétique (40) est prévu.

12. Dispositif selon la Revendication 11, ***caractérisé en ce que*** le système magnétique (40) comprend au moins une bobine à champ magnétique (42) à l'extérieur du conducteur extérieur (18).

13. Dispositif selon la Revendication 11 ou *12,* ***caractérisé en ce que*** le système magnétique (40) comprend des bagues magnétiques (43) et/ou des anneaux polaires à l'extérieur du conducteur extérieur (18).

14. Dispositif selon l'une quelconque des Revendications 11 à 13, ***caractérisé en ce que*** le système magnétique (40) comprend des barres polaires ou des aimants en barre (44) dans le conducteur intérieur (19).

15. Dispositif selon l'une quelconque des Revendications 1 à 14, ***caractérisé en ce qu*'**un système de capteurs est prévu pour surveiller le plasma (25) dans la zone plasma (20).
